# EUROPEAN PATENT APPLICATION

(11) **EP 1 612 941 A1**
(43) Date of publication of application: **04.01.2006**
(21) Application number: 04291624.7
(22) Date of filing: 28.06.2004
(51) Int. Cl.: H03K 19/0175

(54) **Power level converter circuit**

(71) Applicant: ALCATEL, 75008 Paris (FR)
(72) Inventor: Ilchmann, Frank, 13158 Berlin (DE)
(74) Representative: Kohler Schmid Möbus

(57) **Abstract**

The invention relates to a power level converter circuit (1) for converting first input signals (CMOS+, CMOS-) delivered by a first circuit part operating at a first supply voltage (Vdd) into output signals (ECL+, ECL-) for a second circuit part operating at a second, different operating voltage (Vcc), the level converter circuit (1) comprising a level shifter stage (2) receiving the input signals (CMOS+, CMOS-) and being connected to the supply voltage (Vcc) of the second circuit part and to a current switch stage (3) delivering the output signals (ECL+, ECL-), wherein the level shifter stage (2) is also connected to a supply voltage (Vdd) of the first circuit part, and comprises a protection means for protecting the first circuit part. Thus, the first circuit part can be protected from the high operating voltage of the second circuit part

## Description

### Background of the invention

The invention relates to a power level converter circuit for converting first input signals delivered by a first circuit part operating at a first supply voltage into output signals for a second circuit part operating at a second, different operating voltage, the level converter circuit comprising a level shifter stage receiving the input signals and being connected to the supply voltage of the second circuit part and to a current switch stage delivering the output signals.

Converters are used to adjust different logic levels. The converter has the task of converting signals at the corresponding frequency. Such signals occur, p. ex., between active components within a chip or between two chips. These components may be arranged close to one another or be spaced apart. For example, such components may be connected via a bus. The components may be integrated in network elements having a fair distance from one another.

Signal exchanging systems, in general telecommunications systems or networks, have to exchange (electrical) signals reliably and as quickly as possible. In order to achieve this, defined uniform transmission rates (frequencies) and defined amplitudes are used.

From a technological point of view it is possible and desirable to convert CMOS (Complementary Metal Oxide Semiconductor) signals with high power (potential) level into signals with lower power (potential) level, p. ex. signals of ECL (Emitter Coupled Logic) circuits, without a significant loss in velocity, such that a converter can supply ECL circuits with appropriate signals.

In the state of the art solutions are known for circuits comprising an ECL part and a CMOS part, both being connected to the same operating voltage. Hence, the converter is connected to the common operating voltage as well.

The trend for further miniaturization of semiconductor technologies leads to a decrease in allowable operating voltages for ECL and CMOS circuit parts. However, in order to fully benefit from the ECL and CMOS circuits, different operating (supply) voltages must be used for the ECL and CMOS parts. Bipolar ECL circuit parts typically operate in the range from 2.5 to 5.0 V. In contrast, the operating voltage of CMOS circuit parts, at present, is typically below 2.0 V, p.ex. 1.8 V or even 1.2 V.

This implies that at the interface between CMOS and ECL circuit parts not only the CMOS signal level swing of a few V must be decreased to a few hundred mV, but also the potential (signal level) of the CMOS signals must be shifted towards a much higher potential (signal level) for the ECL signals.

Furthermore, ECL and CMOS circuit parts are often allocated to different voltage supply systems, which may vary within given tolerances. However, the supply voltage of one system may be at the upper tolerance level and the supply voltage of the other system may be at the lower tolerance level, thus further increasing the difference between the operating voltages. Additionally, the variations of the supply voltages may vary independent from one another.

Additionally, one has to consider that quite often a reduction in the maximum allowable voltage for the integrated devices comes along with a reduction of the operating voltages. One has to prevent the voltage supplied to the CMOS transistors to rise above certain limits in order to avoid destruction of the transistors.

In EP 1 376 867 A1 a differential high-speed CMOS to ECL logic converter has been disclosed. A common operating voltage is provided for the CMOS and ECL circuit part. If this converter is to be used in the case of separated and different CMOS and ECL operating voltages, the common operating voltage would have to be connected to the ECL circuit part. The full ECL operating voltage would, in this case, be applied to the gate and source of the PFETs. If the ECL operating voltage is above the allowable maximum gate source voltage, the PFETs are destroyed. If the common operating voltage was separated in the converter, in order to connect the PFET input stage to the CMOS supply and the output stage to the ECL supply, the following effects would occur:
The ECL output stage requires a minimum input voltage which may be derived from the sum of the voltage across the current source, the diode forward voltage and the ECL signal level swing. The voltage at the current source is typically 1 V at the collector of Q4 (0.2 V across R5 and a diode forward voltage of approx. 0.8 V). The diode forward voltage at Q1/Q2 is also approx. 0.8 V and the ECL signal level swing is p. ex. 0.2 V. Thus, a minimum input voltage of approx. 2 V may be derived. If the voltage falls below that value, the collector potential at the current source transistor Q4 becomes lower than the base potential. Thus the transistor Q4 goes into saturation. First, the switching times increase, and then the current source does not deliver any current any more.

### Object of the invention

It is the object of the invention to provide a level converter circuit for converting signals from a first circuit part operating at a first operating voltage to signals suitable for a second circuit part operating at a second operating voltage.

### Short description of the invention

This object is achieved by a power level converter circuit mentioned above, wherein the level shifter is also connected to the supply voltage of the first circuit part, and comprises a protection means for protecting the first circuit part. Thus, the first circuit part can be protected from the high operating voltage of the second circuit part. This allows the level converter circuit to operate in a wide range of different power supply voltages for the first and second circuit part. The protection means fulfills the task of protecting the first circuit part, in particular a CMOS part, against high-voltage breakdown. This is particularly advantageous, if the CMOS part is to be operated at very low supply voltages. P. ex., in the future the CMOS supply voltage will likely be reduced to 1.2 V. Very fast level conversion, in particular with propagation delays below 50 ps, will be possible because of a small number and small size of active devices which are only necessary for realizing the protection means. The CMOS part will be protected reliably against high-voltage breakdown from the ECL part.

In a particularly preferred embodiment the protection means comprises at least one cascode stage. The cascode stage makes the signal level swing of the level shifter stage independent from variations of both operating voltages.

In a particularly preferred embodiment the cascode stage comprises a field effect transistor and a bipolar transistor, wherein the base of the bipolar transistor is connected to the supply voltage of the first circuit part and the gate of the field effect transistor is supplied with an input signal. This is particularly advantageous, if the first circuit part is a CMOS circuit part and the second circuit part is a bipolar, in particular an ECL circuit part. The field effect transistor is capable of directly receiving a CMOS signal as triggering signal. If a bipolar transistor was used instead of the field effect transistor, the signal level of the CMOS signal would have to be adjusted.

Normally, a cascode stage consists of two devices of the same type, i.e. two field effect transistors or two bipolar transistors. By choosing a bipolar transistor as the cascode element, this element may be connected to the operating voltage of the second circuit part, in particular to the ECL operating voltage. Hence, the cascode element may be used for protecting the field effect transistor of the cascode stage and the first circuit part connected to the field effect transistor. Preferably, the field effect transistor is an NFET and the bipolar transistor is an npn transistor.

In an advantageous embodiment the level shifter stage comprises at least one load element arranged between the cascode stage and the supply voltage of the second circuit part. The input signal, in particular a differential input signal, triggers the field effect transistor, in particular an NFET transistor, which is connected to load element, in particular a resistor. The differential branch signal for triggering the current switch stage is tapped at the load element. The bipolar transistor of the cascode stage is disposed in a common base configuration between the field effect transistor and the load element. The base terminal of the cascode transistor is connected to the operating voltage of the first circuit part, in particular a CMOS operating voltage. The current switch stage, in particular an ECL current switch stage, generates the output signal compatible with the second circuit part, in particular compatible with an ECL circuit part.

Even though the load elements of the field effect transistors are connected to the operating voltage of the second circuit part, i.e. the ECL operating voltage, the field effect transistor is separated from the high operating voltage of the second circuit part. Even in the case that no operating voltage of the first circuit part is supplied, the reverse biased collector base diode of the cascode element (bipolar transistor) protects the field effect transistor. The cascode stage makes the signal level swing of the level shifter stage independent from variations of the two operating voltages. The signal level swing may be derived from the load element and the current, which the field effect transistor allows to flow. This current is, however, only determined by the operating voltage of the first circuit part reduced by the diode forward voltage of the cascode transistor, and the width and the length of the field effect transistor. It is not determined by the voltage between the collector of the cascode element and the operating voltage of the second circuit part. This is due to the fact that the cascode element is operated in common base mode. This results in a current control, i.e. the current drawn at the collector corresponds to the emitter current, the collector voltage does not affect the current drawn. The correct driving of the current switch stage is ensured in that the load element is connected to the operating voltage of the second circuit part. The drive potential is therefore independent from the voltage difference between the first and second circuit part.

Since the level shifter stage only has to reverse the base current of the current switch stage, the field effect transistor may be very small. Thus the reversing process is shortened and reversing times of below 50 ps may be achieved.

The minimum operating voltage of the first circuit part, which may be used for operating the converter, may be determined from the voltage, which is supplied to the field effect transistor of the level shifter stage and the diode forward voltage of the cascode element. The diode forward voltage is approx. 0.8 V, and at least 0.2 V should be applied to the field effect transistor. If this voltage is too small, the field effect transistor has to be dimensioned relatively large, in order to be able to switch the necessary current. Hence, the reversing times become larger. As minimum operating voltage for the first circuit part a voltage of approx. 1 V is therefore derived.

In a particularly preferred embodiment the level shifter comprises two identical branches, each comprising a cascode stage and a load element, and the current switch stage comprises two branches with a bipolar transistor each, wherein the branch outputs of the level shifter stage are connected to the bases of the two transistors of the current switch stage. This arrangement may be used for converting differential input signals, in particular differential CMOS signals, into differential output signals, in particular differential ECL signals.

Advantageously a signal level swing adjusting means is provided for adjusting the signal level swing of the output signal. The signal level swing may be defined by a reference voltage, which is needed anyway in subsequent ECL circuit parts.

A central application for such a level converter may be a transmission (network) equipment for communication networks.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawings

The invention is shown in the drawing.
- **Fig. 1**: shows a simplified schematic diagram of the preferred design of the level converter of the present invention;
- **Fig. 2**: shows waveforms illustrating the switching characteristics of the level converter of the present invention shown in Fig. 1.

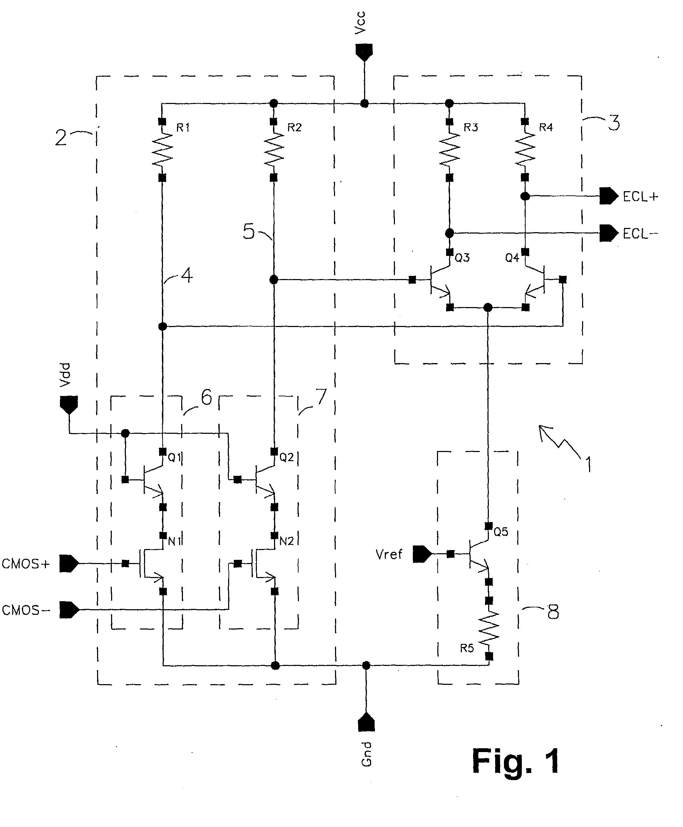

The high-speed logic level converter circuit 1 of the present invention is shown in simplified form in **Fig. 1**. The level converter circuit 1 is designed to translate a differential complementary pair of input signals CMOS+, CMOS- originating from a first circuit part from a potential associated with CMOS logic levels into a differential complementary pair of output signals ECL+, ECL-, that are at potentials associated with ECL logic levels. It is contemplated that the potentials associated with the output signals may be generated by the converter circuit 1 at levels other than those related to ECL. The level converter circuit 1 comprises a level shifter stage 2 and a current switch stage 3. Both, the level shifter stage 2 and the current switch stage 3 are connected to the operating voltage Vcc of a second circuit part, which is supplied with the output signals ECL+, ECL-.

The level shifter stage 2 comprises two branches 4, 5, each comprising a cascode stage 6, 7 and a load element R1, R2. The cascode stages 6, 7 each comprise a field effect transistor N1, N2 embodied as NFET and a bipolar transistor Q1, Q2 in a common base arrangement embodied as npn bipolar transistor. The bases of the transistors Q1, Q2, which are used as cascode elements, are connected to the operating voltage Vdd of the first circuit part.

The emitters of the transistors Q1, Q2 are connected to the drains of the transistors N1, N2, which receive the input signals CMOS+, CMOS- at their gates, respectively. The differential input signals for the current switch stage 3 are tapped from the branches 4, 5 next to the load elements R1, R2.

The field effect transistors N1, N2, which are the active elements of the level converter circuit 2, effecting the level conversion, are protected by the cascode elements Q1, Q2, even if no operating voltage Vdd of the first circuit part is supplied to the base of the transistors Q1, Q2. Thus, the field effect transistors N1, N2 are separated from the high operating voltage of the second circuit part. The transistors Q1, Q2 are controlled by the transistors N1, N2 and always deliver the necessary current. If the transistors N1, N2 become more conductive due to changing input signals CMOS+, CMOS-, the drain voltage of the transistors N1, N2 is reduced and thus the emitter voltage of the transistors Q1, Q2. Since the base voltage of the transistors Q1, Q2 is constant, the base emitter voltage increases, and therefore also the base current, the collector, and the emitter current of the transistors Q1, Q2. The current flows to the load element R1, R2 and causes a voltage drop.

If the input signal CMOS+ corresponds to a logic level "high" the field effect transistor N1 becomes conductive, and therefore the transistor Q4 connected to the branch 6, becomes non-conductive. Therefore, the output signal ECL+ also shows a logic level "high". In contrast, if the input signal CMOS+ corresponds to the logic level "low", the field effect transistor N1 becomes non-conductive and the transistor Q4 becomes conductive. This results in the logic level of the output signal ECL+ to become "low". A change in the logic level of the input signal CMOS- has the analogous effect on the output signal ECL-.

The signal level swing of the output signals ECL +, ECL- may be adjusted by a signal level swing adjusting means 8 embodied as a current source, which comprises a transistor Q5 and a resistor R5. By setting a reference voltage V_{ref}, the signal level swing of the output signals ECL+, ECL- may be adjusted.

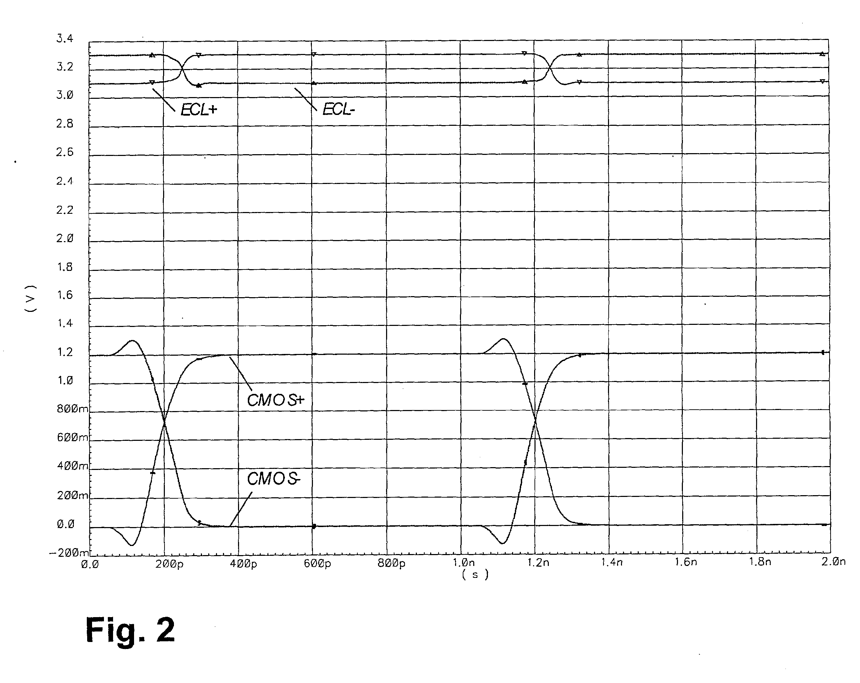

**Fig. 2** provides an illustration of the advantage in using the converter of Fig. 1. The waveform labelled with CMOS+ is the first CMOS level signal supplied to the level converter circuit and the waveform labelled with CMOS- is the second input signal supplied to the level converter circuit. The input signals CMOS+, CMOS- originate from a circuit part with a supply (operating) voltage of 1.2 V. The waveforms labeled with ECL+, ECL- correspond to the output signals at the output of the current switch stage, and thus of the level converter circuit. The ECL signals are supplied to a second circuit part operating at a supply (operating) voltage of 3.3 V. It can be seen that a change in the logic level of a differential CMOS input signal forces a change of the corresponding differential ECL output signal within approx. 50 ps. A logic "low" at the input results in a logic "low" at the output and a logic "high" in the input results in a logic "high" at the output of the corresponding output signal. Thus, in the example of the present invention, full-swinging CMOS input signals may be translated into a differential pair of ECL output signals having a signal level swing of about 0.2 V.

## Claims

1. Power level converter circuit (1) for converting first input signals (CMOS+, CMOS-) delivered by a first circuit part operating at a first supply voltage (Vdd) into output signals (ECL+, ECL-) for a second circuit part operating at a second, different operating voltage (Vcc), the level converter circuit (1) comprising a level shifter stage (2) receiving the input signals (CMOS+, CMOS-) and being connected to the supply voltage (Vcc) of the second circuit part and to a current switch stage (3) delivering the output signals (ECL+, ECL-), **characterized in that** the level shifter stage (2) is also connected to a supply voltage (Vdd) of the first circuit part, and comprises a protection means for protecting the first circuit part.

2. Converter according to claim 1, **characterized in that** the protection means comprises at least one cascode stage (6, 7).

3. Converter according to claim 2, **characterized in that** the cascode stage (6, 7) comprises a field effect transistor (N1, N2) and a bipolar transistor (Q 1, Q2), wherein the base of the bipolar transistor (Q1, Q2) is connected to the supply voltage (Vdd) of the first circuit part and the gate of the field effect transistor (N1, N2) is supplied with an input signal (CMOS+, CMOS-).

4. Converter according to claim 3, **characterized in that** the field effect transistor (N1, N2) is an NFET and the bipolar transistor (Q1, Q2) is an npn-transistor.

5. Converter according to claim 1, **characterized in that** the level shifter stage (2) comprises at least one load element (R1, R2) arranged between the cascode stage (6, 7) and the supply voltage (Vcc) of the second circuit part.

6. Converter according to claim 1, **characterized in that** the level shifter stage (2) comprises two identical branches (4, 5), comprising a cascode stage (6, 7) and a load element (R1, R2), and the current switch stage (3) comprises two branches with a bipolar transistor (Q3, Q4) each, wherein the branch outputs of the level shifter stage (2) are connected to the bases of the two transistors (Q3,Q4) of the current switch stage (3).

7. Converter according to claim 1, **characterized in that** a signal level swing adjusting means (8) is provided for adjusting the signal level swing of the output signal (ECL+, ECL-).

8. Converter according to claim 1, **characterized in that** the converter (1) is a differential CMOS to ECL converter.

9. Transmission network equipment comprising a converter (1) according to claim 1.
